# EUROPEAN PATENT APPLICATION

(11) **EP 4 580 371 A1**
(43) Date of publication of application: **02.07.2025**
(21) Application number: 24195674.7
(22) Date of filing: 21.08.2024
(51) Int. Cl.: H10K 59/131, H10K 59/88

(54) **DISPLAY DEVICE**

(30) Priority: 29.12.2023 KR 20230196667
(71) Applicant: LG Display Co., Ltd., Seoul 07336 (KR)
(72) Inventor: KIM, Taehwi, Paju-si, Gyeonggi-do 10845 (KR)
(74) Representative: Viering, Jentschura & Partner mbB Patent- und Rechtsanwälte

(57) **Abstract**

Disclosed is a display device (10) that prevents an appearance defect due to a density difference between a normal area of a display area (AA) and a portion of the display area (AA) in which a data link meets with the normal area from being perceived. To this end, an anode (AE) electrode of each pixel (PX) disposed on top of a planar hole (PLN_H) in the area where the data link meets with the normal area extends into the planar hole (PLN_H) to shield and fill the planar hole (PLN_H) to reduce the density difference as caused by the planar hole (PLN_H) to implement a narrow bezel while improving a yield.

## Description

### Field

The present disclosure relates to a display device, and more specifically, to a display device in which a narrow bezel is implemented by changing connection of a data link disposed in a display area.

### Background

An organic light-emitting display device is a self light-emitting display device. Unlike a liquid crystal display device (LCD), the organic light-emitting display device does not require a separate light source and may be manufactured in a lightweight and thin form. Furthermore, the organic light-emitting display device is not only advantageous in terms of power consumption due to low-voltage operation, but also have excellent color reproduction, response speed, viewing angle, and contrast ratio (CR), and thus is being studied as a next-generation display.

The organic light-emitting display device uses a plurality of thin film transistors (TFT) to control current flowing through organic light-emitting diodes to display an image. Further, a structure in which a touch electrode is formed on a display panel to enable touch operation is applied to the organic light-emitting display device.

The organic light-emitting display device may be folded or bent into various shapes using a flexible substrate. In order to enlarge a display area of the display device and reduce a bezel area, a pad to which a printed circuit board is connected may be disposed on an opposite surface to a surface having the display area. For this purpose, a bent area where the flexible substrate is bent may be defined.

### SUMMARY

However, in the organic light-emitting display device, a bezel area at a bottom corner of a display area becomes slim by disposing a data link to extend across the display area.

The data link in the display area for a narrow bezel transmits and receives vertical and horizontal signals via a planar hole. As a result, due to the planar hole, a density difference between a normal area of the display area and a portion of the display area in which the data link meets with the normal area may occur.

Therefore, an appearance defect in which this density difference is perceived occurs.

In order to solve the above-mentioned problem, the inventor of the present disclosure has invented a display device that prevents the appearance defect due to the planar hole in the portion of the display area in which the data link meets with the normal area.

Furthermore, a purpose of the present disclosure is to provide a display device in which an anode electrode of each pixel disposed on top of the planar hole in the area where the data link meets with the normal area extends into the planar hole to shield the planar hole to reduce the density difference as caused by the planar hole to implement a narrow bezel while improving a yield.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof. According to an aspect of the present disclosure, a display device according to claim 1 is provided. According to another aspect of the present disclosure, a display device according to claim 11 is provided. According to another aspect of the present disclosure, a display device according to claim 14 is provided. Further embodiments are described in the dependent claims.

One aspect of the present disclosure provides a display device comprising: a display panel including a display area in which at least one pixel is disposed, and a non-display area disposed around the display area; a data driver disposed in the non-display area; at least one data wiring respectively connecting the at least one pixel to the data driver; and at least one first wiring disposed between at least two data wirings and in the non-display area, and extending into the display area, wherein the at least one first wiring is bent in the display area so as to intersect the data wirings, wherein the display area includes a first area where the at least one pixel is disposed, and a link area other than the first area, wherein the link area includes: a (1-1)-th area located on a lower portion of one of both opposing sides of the display area; and a (1-2)-th area located on a lower portion of the other of the both opposing sides of the display area, wherein the at least one first wiring is respectively connected to the at least one data wiring or at least one power wiring via a planar hole in each of the first area, the (1-1)-th area, and the (1-2)-th area.

Another aspect of the present disclosure provides a display device comprising: a display panel including a light-emitting element, a display area, a non-display area and a bent area; a gate driver configured to supply a gate signal to the display panel; an upper substrate disposed on the display panel and in the display area; a bent protective layer disposed on an outer surface of a bent portion of the display panel and in the bent area; a data driver disposed under the bent portion of the display panel and in the non-display area and configured to supply a data voltage to the display panel; a controller configured to control the gate driver and the data driver; at least one data wiring respectively connecting the at least one pixel to the data driver; at least one power wiring for respectively supplying power to the at least one pixel; and at least one first wiring disposed between at least two data wirings and in a layer different from a layer of the at least one data wiring, wherein the at least one first wiring is bent in the display area so as to intersect the data wirings, wherein the display area includes a first area where the at least one pixel is disposed, and a link area other than the first area, wherein the link area includes: a (1-1)-th area located on a lower portion of one of both opposing sides of the display area; and a (1-2)-th area located on a lower portion of the other of the both opposing sides of the display area, wherein the at least one first wiring is respectively connected to the at least one data wiring or the at least one power wiring via a planar hole in each of the first area, the (1-1)-th area, and the (1-2)-th area.

Another aspect of the present disclosure provides a display device comprising: a display panel including a display area in which at least one pixel is disposed, and a non-display area disposed around the display area; a data driver disposed in the non-display area; at least one data wiring respectively connecting the at least one pixel to the data driver; and a plurality of first wirings disposed between at least two data wirings and in the non-display area, and extending into the display area, wherein the plurality of first wirings are bent in the display area so as to intersect the data wirings, wherein the display area includes a first area where the at least one pixel is disposed, and a link area other than the first area, wherein the link area includes: a (1-1)-th area located on a lower portion of one of both opposing sides of the display area; and a (1-2)-th area located on a lower portion of the other of the both opposing sides of the display area, wherein the plurality of first wirings comprise a wiring connected to the at least one data wiring or at least one power wiring via a planar hole in the first area, a wiring connected to a dummy wiring extending in a column direction via a planar hole in the (1-1)-th area, and a wiring connected to the at least one data wiring via a planar hole in the (1-2)-th area.

Details of other embodiments are included in the detailed description and drawings.

The technical solutions according to the embodiment of the present disclosure are not limited to the solutions mentioned above, and other solutions not mentioned will be clearly understood by those skilled in the art from the description below.

The display device according to an embodiment of the present disclosure may realize slimming of the bezel area at a lower corner of the display area by placing the data link so as to extend across the display area of the display panel.

Furthermore, in the display device according to an embodiment of the present disclosure, the anode electrode may extend into the area in which the data link meets with the normal area of the display area so as to cover and fill the planar hole, thereby reducing the density difference due to the planar hole. Therefore, the display device according to an embodiment of the present disclosure may implement a narrow bezel in addition to improving a yield.

Furthermore, in the display device according to an embodiment of the present disclosure, the appearance defect due to the density difference due to the planar hole in the area in which the data link meets with the normal area of the display area may be prevented from being perceived, thereby improving a quality of the display device.

Further, according to an embodiment of the present disclosure, as the quality of the display device is improved, reliability thereof may be secured, thereby improving a lifespan of the display panel and implementing a long-life display device.

In addition to the above effects, specific effects of the present disclosure are described together while describing specific details for carrying out the present disclosure.

Effects of the present disclosure are not limited to the effects mentioned above, and other effects not mentioned will be clearly understood by those skilled in the art from the descriptions below.

### BRIEF DESCRIPTION OF DRAWINGS

FIG. 1 is a plan view of a display panel of a display device according to an embodiment of the present disclosure.
FIG. 2 is a cross-sectional view taken along a line A-A' in FIG. 1.
FIG. 3 is a plan view of a display device in which an area B of FIG. 1 is enlarged.
FIG. 4 is a cross-sectional view of a display device according to an embodiment of the present disclosure.
FIG. 5 is a plan view of a display device in which an area B of FIG. 3 is enlarged.
FIG. 6 is a cross-sectional view of a display panel according to an embodiment of the present disclosure as cut along a line C-C' in FIG. 3.
FIG. 7 is a diagram showing a display area including a link area in a display panel according to an embodiment of the present disclosure.
FIG. 8 is a diagram showing an example of dividing a display area into areas according to an embodiment of the present disclosure.
FIG. 9 is a diagram showing an example of a wiring arrangement in a first area, a (1-1)-th area, a second area, and a third area of a display area according to an embodiment of the present disclosure.
FIG. 10 is a diagram showing an example of a wiring arrangement in a (1-2)-th area of the display area according to an embodiment of the present disclosure.
FIG. 11 is a diagram showing a line layout in first to third areas of a link area according to an embodiment of the present disclosure.
FIG. 12 is a cross-sectional view of a line arrangement in a first area of a link area according to an embodiment of the present disclosure.
FIG. 13 is a cross-sectional view of a line arrangement in second and third areas of a link area according to an embodiment of the present disclosure.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to entirely inform the scope of the present disclosure to those of ordinary skill in the technical field to which the present disclosure belongs, and the present disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for describing embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like is disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like may be disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the spirit and scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

The features of the various embodiments of the present disclosure may be partially or entirely combined with each other, and may be technically associated with each other or operate with each other. The embodiments may be implemented independently of each other and may be implemented together in an association relationship.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for describing embodiments.

Further, in a specific case, a term may be arbitrarily selected by the applicant, and in this case, the detailed meaning thereof will be described in a corresponding description section. Therefore, the terms used in the description below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B via another node unless a phrase 'immediately transferred' or 'directly transferred' is used.

As used herein, the term "display device" may include, in a narrow sense, a display device including a liquid crystal module (LCM), an organic light-emitting diode (OLED) module, or a quantum dot (QD) module including a display panel and a driver for driving the display panel. Moreover, the display device may include, in a broad sense, a laptop computer, a television, a computer monitor, an automotive device or an equipment display for a vehicle, a set electronic device, a set device or a set apparatus including a complete product or a final product including the LCM, the OLED module, or the QD module.

Therefore, the display device in accordance with the present disclosure may include, in the narrow sense, a display device itself including, for example, the LCM, the OLED module, QD module, etc., and may include, in a broad sense, the set device as an application product or an end-user device including a complete product or a final product including the LCM, the OLED module, or the QD module.

Moreover, in some cases, the LCM, OLED module, or QD module composed of the display panel and the driver may be expressed as "display device" in a narrow sense. The electronic device as a complete product including the LCM, OLED module or QD module may be expressed as "set device" in a broad sense. For example, the display device in the narrow sense may include a display panel such as a liquid crystal panel, an organic light-emitting display panel, or a quantum dot display panel, and a source PCB as a controller for driving the display panel. The set device in the broad sense may include a display panel such as a liquid crystal panel, an organic light-emitting display panel, or a quantum dot display panel, a source PCB as a controller for driving the display panel, and a set PCB as a set controller that is electrically connected to the source PCB and controls the set device.

As used herein, the display panel may be of any type of the display panels such as a liquid crystal display panel, an organic light emitting diode (OLED) display panel, a quantum dot (QD) display panel, and an electroluminescent display panel, etc. Embodiments are not limited thereto. For example, the display panel may be embodied as a display panel which may be vibrated by a vibrating device according to an embodiment of the present disclosure to generate a sound. A display panel applied to a display device according to an embodiment of the present disclosure is not limited to a shape or a size of the display panel.

Hereinafter, a display device according to an embodiment of the present disclosure will be described with reference to the drawings.

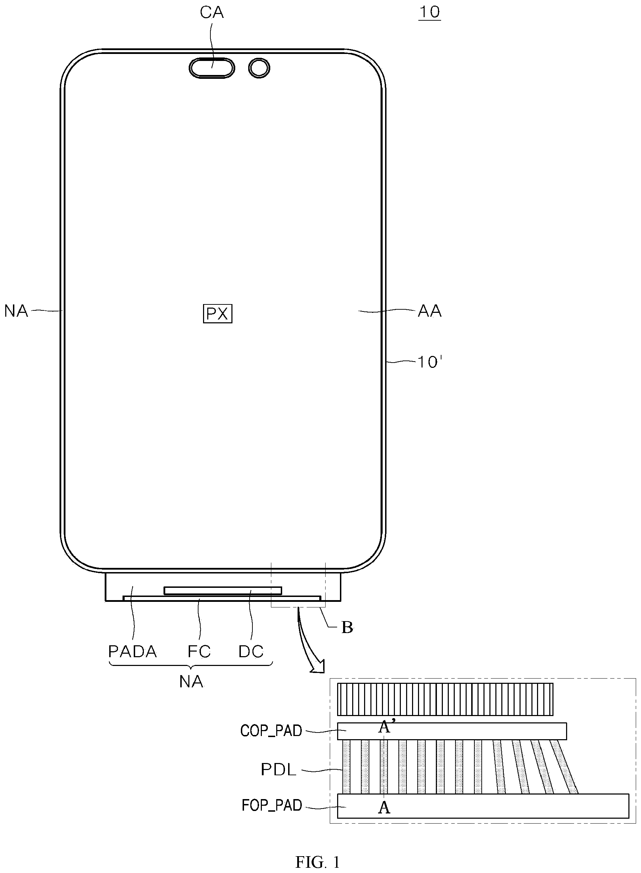

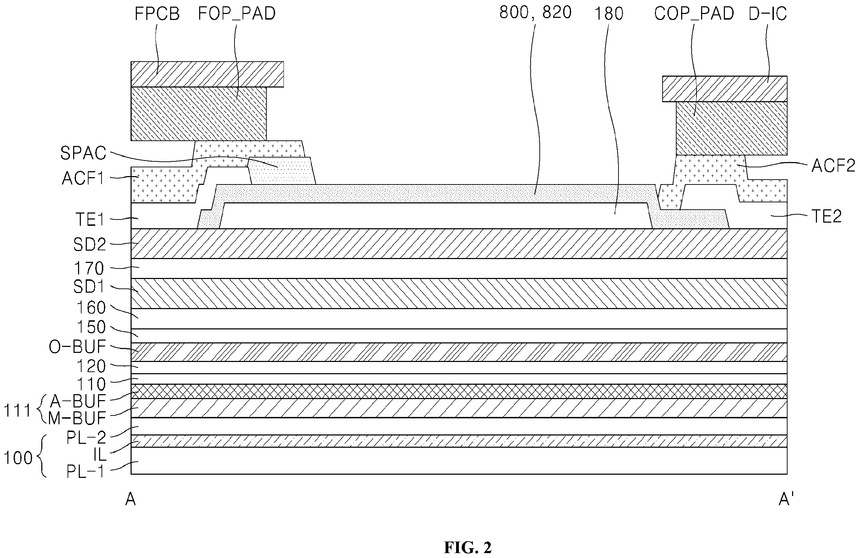

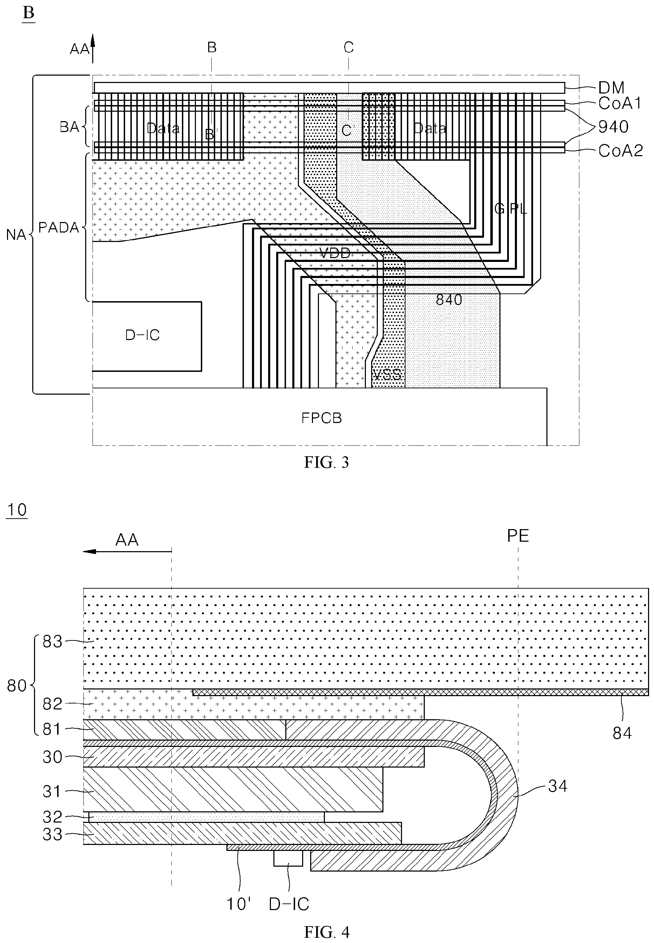

FIG. 1 is a plan view of a display panel of a display device according to an embodiment of the present disclosure. FIG. 2 is a cross-sectional view taken along a line A-A' in FIG. 1. FIG. 3 is a plan view of a display device in which an area B of FIG. 1 is enlarged.

Referring to FIG. 1, a display device 10 according to an embodiment of the present disclosure may include a display panel 10' that implements image display.

The display panel 10' may include a plurality of areas. For example, the display panel 10' may include a display area (Active Area) AA in which at least one pixel PX is disposed, and a non-display area (Non-Active Area) NA disposed around the display area AA. The display area AA is an area where an image is displayed, and a pixel array PXL is formed.

One or more non-display areas NA in which visual images are not displayed may include a driver circuit and a dam and may be provided on one side of the display area AA. For example, the non-display area NA may be adjacent to one or more sides of the display area AA.

The non-display area NA surrounds a rectangular display area AA and may be located out thereof. However, it should be understood that a shape of the display area AA and a position of the non-display area NA adjacent to the display area AA are not specifically limited to those in the display device 10 as shown in FIG. 1. Each of the display area AA and the non-display area NA may have any shape. Examples of these shapes may include a pentagon, a hexagon, a circle, an oval, etc. An embodiment of the present disclosure is not limited thereto.

The non-display area NA of the display panel 10' may include an area surrounding the display area AA, a pad wiring area PADA, a FPCB connection area FC, and a D-IC connection area DC.

The FPCB connection area FC may include a first pad FOP_PAD, and the D-IC connection area DC may include a second pad COP_PAD. The first pad FOP_PAD may be connected to the second pad COP_PAD through a plurality of pad wirings (Pad Data Line) PDL. In this regard, the pad wiring PDL may be a wiring for input and output of the second pad COP_PAD and may be referred to as a fanout line.

Furthermore, a camera hole CA where a camera is disposed may be included within the display area AA. The display device 10 may include at least one camera hole CA. For example, the display device 10 may include at least one camera module overlapping at least one camera hole CA. However, an embodiment of the present disclosure is not limited thereto. For example, the display device 10 may include an optical device including a camera module.

When the display panel 10' has been bent, the pad wiring area PADA, the FPCB connection area FC, and the D-IC connection area DC of the display panel 10' may constitute a bottom of the display panel 10'.

Each pixel PX of the display area AA includes a plurality of sub-pixels SP, and the plurality of sub-pixels SP may display red (R), green (G), blue (B), and white (W) colors, etc. The plurality of sub-pixels SP may be disposed in the display area AA, and each thereof may include one or more transistors ST1 and ST2, etc. At least one transistor and a light-emitting element EL may be connected to each other.

Additionally, each of the pixels PX and the sub-pixels SP may be associated with a pixel circuit including one or more TFTs manufactured on a substrate of the display device 10. Each pixel circuit may be electrically connected to a gate line GL and a data wire DL to communicate with one or more driver circuits, for example, a gate driver GIP and a data driver D-IC located in the non-display area NA of the display device 10.

The gate driver GIP supplies a gate signal SCAN to the display panel 10'.

One or more driver circuits may be implemented with TFTs disposed within the non-display area NA. For example, the gate driver GIP may be implemented using a plurality of TFTs on the substrate of the display device 10. Non-limiting examples of circuits that may be implemented with the TFTs on the substrate may include an inverter circuit, a multiplexer, and an electrostatic discharge (ESD) circuit. However, embodiments of the present disclosure are not limited thereto.

Some driver circuits may be embodied as an integrated circuit (IC) chip and may be mounted within the non-display area NA of the display device 10 using chip-on-glass COG or other similar schemes. Furthermore, some driver circuits may be mounted on another substrate, and may be coupled to a connection interface (pads/bumps, pins) disposed in the non-display area NA using a flexible circuit board (FPCB), a chip-on-film (COF), a tape-carrier-package (TCP), or other suitable schemes.

In embodiments of the present disclosure, at least two different types of TFTs may be disposed in a TFT substrate for a display device. The types of TFTs employed in a portion of the pixel circuit and a portion of the driving circuit may vary according to the requirements of the display device.

For example, the pixel circuit may be implemented as a TFT (oxide TFT) with an oxide active layer. The driving circuit may be implemented as a TFT (LTPS TFT) with a low-temperature polycrystalline silicon active layer and a TFT with an oxide active layer. Unlike the LTPS TFTs, the oxide TFTs do not suffer from pixel-to-pixel threshold voltage Vth variation. A uniform threshold voltage Vth may also be obtained in an array of pixel circuits for display. The uniformity problem of the threshold voltages Vth of the TFTs implementing the driving circuit will have less direct impact on the luminance uniformity of the pixels.

Using the driving circuits on the substrate to be implemented as the LTPS TFTs, signals and data may be provided to pixels at a higher clock than that when all TFTs in the TFT panel are embodied as oxide TFTs. Therefore, the display device capable of high-speed operation may be realized without stains such as mura. For example, the advantages of the oxide TFT and the LTPS TFT are combined with the design of the TFT panel such that the oxide TFT and the LTPS TFT may be selectively used according to the advantage thereof.

The flexible circuit board FPCB may be connected to the display panel 10' and may be disposed in the non-display area NA.

The data driver D-IC may be connected to the display panel 10' and may be disposed to spaced apart from the flexible circuit board FPCB. The data driver D-IC may be disposed in the non-display area NA, and may apply a high potential driving voltage EVDD and a data voltage Vdata to the display panel 10'.

Referring to FIG. 2, the display device 10 according to an embodiment of the present disclosure may include a buffer layer 111 disposed on a substrate 100 and a first insulating layer 110 disposed on the buffer layer 111, and a first gate insulating layer 120 disposed on the first insulating layer 110 in the non-display area NA.

In this regard, the substrate 100 may include a first polyimide layer PL-1, an intermediate layer IL thereon, and a second polyimide layer PL-2 thereon. The buffer layer 111 may include a first buffer layer M-BUF and a second buffer layer A-BUF thereon.

Furthermore, the display device 10 may include a third buffer layer O-BUF on the first gate insulating layer 120, a second gate insulating layer 150 on the third buffer layer O-BUF, and a fourth insulating layer 160 disposed on the second gate insulating layer 150 in the non-display area NA.

Furthermore, in the non-display area NA, the display device 10 may include a pad wiring PDL on the fourth insulating layer 160, a second planarization layer 180 on the pad wiring PDL, an insulating layer 800 and 820 on the second planarization layer 180, and a first touch electrode TE1, a sealing layer SPAC, and a second touch electrode TE2 disposed on the pad wiring PDL and the insulating layer 800 and 820.

In this regard, the insulating layer 800 and 820 may include the touch buffer layer 800 and the touch insulating layer 820, and may be disposed on the pad wiring PDL to entirely cover the second planarization layer 180.

Furthermore, in the non-display area NA, a first adhesive layer ACF1 may be disposed on the first touch electrode TE1 and the sealing layer SPAC, a first pad FOP_PAD may be disposed on the first adhesive layer ACF1, and a flexible circuit board FPCB may be disposed on the first pad FOP_PAD.

Furthermore, in the non-display area NA, a second adhesive layer ACF2 may be disposed on the second touch electrode TE2, a second pad COP_PAD may be disposed on the second adhesive layer ACF2, and the data driver D-IC may be disposed on the second pad COP_PAD.

Although not shown in FIG. 2, the insulating layer 800 and 820 may be disposed on a light-emitting element EL in the display area AA. In the non-display area NA, a plurality of touch electrodes TE1 and TE2 may be disposed on the insulating layer 800 and 820, and a plurality of adhesive layers ACF 1 and ACF2 may be disposed on the plurality of touch electrodes TE1 and TE2, respectively. Although not shown in the drawings, each of the plurality of adhesive layers ACF 1 and ACF2 may include an adhesive resin and a plurality of conductive particles disposed in the adhesive resin.

The first pad FOP_PAD may be disposed on the first adhesive layer ACF1 as one disposed at one side among the plurality of adhesive layers and under the flexible circuit board FPCB in the non-display area NA. The second pad COP_PAD may be disposed on the second adhesive layer ACF2 as one disposed at the other side among the plurality of adhesive layers and under the data driver D-IC in the non-display area NA.

The sealing layer SPAC located between the first adhesive layer ACF1 disposed at one side and the insulating layer 800 and 820 may be disposed on the insulating layer 800 and 820 so as to be in contact with the first touch electrode TE1 disposed at one side among the plurality of touch electrodes.

In this regard, the sealing layer SPAC may include an insulating organic material. The insulating organic material may include at least one of BCB (BenzoCycloButene), acryl resin, epoxy resin, phenolic resin, polyamide resin, or polyimide resin.

The first pad FOP_PAD may be disposed under the flexible circuit board FPCB in the non-display area NA and electrically connected to the flexible circuit board FPCB.

The second pad COP_PAD may be disposed under the data driver D-IC in the non-display area NA and may be electrically connected to the data driver D-IC.

The plurality of touch electrodes TE1 and TE2 may include the first touch electrode TE1 disposed at one side and disposed on the insulating layer 800 and 820 and under the first pad FOP_PAD in the non-display area NA; and the second touch electrode TE2 disposed at the other side and disposed on the insulating layer 800 and 820 and under the second pad COP_PAD in the non-display area NA.

The first adhesive layer ACF1 disposed at one side may be disposed on the first touch electrode TE1 disposed at one side and the sealing layer SPAC and under the first pad FOP_PAD. The second adhesive layer ACF2 disposed at the other side may be disposed on the insulating layer 800 and 820 and the second touch electrode TE2 disposed at the other side and under the second pad COP_PAD so as to cover the second touch electrode TE2 disposed at the other side among the plurality of touch electrodes TE2.

Referring to FIG. 3, wirings extending from the display area AA into the non-display area NA may include a data wiring for transmitting a data signal Data to each pixel, a gate driving line GIPL for transmitting a signal to the gate driver GIP, a high potential voltage line VDD for transmitting a driving voltage, a low potential voltage line VSS, and a touch signal line 840 for transmitting a touch signal.

The gate driving line GIPL may be disposed to overlap the touch signal line 840, the high-potential voltage line VDD, or the low-potential voltage line VSS.

The low-potential voltage line VSS may be disposed between the touch signal line 840 and the high-potential voltage line VDD. The low-potential voltage line VSS or the high-potential voltage line VDD may be disposed between the gate driving line GIPL and the touch signal line 840.

Referring to FIG. 2 and FIG. 3, the low-potential voltage line VSS may be formed in the same layer as a layer of a first wiring SD1 or a second wiring SD2. The high potential voltage line VDD may be formed in the same layer as the layer of the first wiring SD1 or the second wiring SD2.

These signal and voltage lines may be electrically connected to the data driver D-IC and the flexible circuit board FPCB.

At least one data line may connect at least one pixel PX and the data driver D-IC to each other, respectively. At least one power line VSS may supply power to at least one pixel PX.

The data driver D-IC may be disposed to be spaced from the flexible circuit board FPCB by a certain spacing.

The non-display area NA may include a bent area BA and a dam area DM where a dam is disposed to define a position of an encapsulation layer to protect a light-emitting element of the display area AA.

Between the display area AA and the bent area BA, a first connection area CoA1 may be disposed in which a contact hole for connecting the wiring extending from the display area AA into the non-display area NA to a bent wiring of the bent area BA is positioned.

In a second connection area CoA2 beyond the bent area BA, a wiring of the pad wiring area PADA may be connected to the data driver D-IC and the flexible circuit board FPCB.

The bent area BA may be designated as an area between the first connection area CoA1 and the second connection area CoA2. However, embodiments of the present disclosure are not limited thereto.

A plurality of partitioning walls 940 may be disposed in the bent area BA. At least two of the plurality of partitioning walls 940 may be disposed in an area adjacent to the first connection area CoA1, while at least one of the plurality of partitioning walls 940 may be disposed in an area adjacent to the first connection area CoA1. However, embodiments of the present disclosure are not limited thereto.

FIG. 4 is a cross-sectional view of a display device according to an embodiment of the present disclosure.

FIG. 4 schematically shows a cross-sectional view of an area where the display panel 10' is bent in the display device 10.

A first backplate 30 and a second backplate 33 that support the display panel 10' are attached to a bottom of the display panel 10'. The first backplate 30 may be disposed in the display area AA and the first connection area CoA1, while the second backplate 33 may be spaced apart from the first backplate 30 by a certain distance and may be disposed in the pad wiring area PADA, the data driver D-IC area, and the flexible circuit board FPCB area.

In a spacing between the first backplate 30 and the second backplate 33, the display panel 10' may be bent so that a lower surface of the first backplate 30 and a lower surface of the second backplate 33 face each other.

A fixing member 31 may be disposed under the first backplate 30. The fixing member 31 may include an adhesive and a heat dissipation sheet, and may include a metal layer capable of reflecting external light therefrom. However, embodiments of the present disclosure are not limited thereto.

An adhesive member 32 may be disposed under the fixing member 31 to connect the fixing member 31 and the second backplate 33 to each other. The adhesive member 32 may be embodied as a double-sided tape, a double-sided foam adhesive tape, or a double-sided foam adhesive pad.

A single support member may be cut away in the bent area BA such that the first backplate 30 is located on top of the fixing member 31 and under the display panel 10', and the second backplate 33 is located under the fixing member 31 and on a rear surface of the display panel 10'. In this regard, the single support member may be cut away in the bent area BA such that the display panel 10' is exposed in the bent area BA, and then, a bent protective layer 34 and the display panel 10' may be bent in the bent area BA such that the second backplate 33 may be attached to the fixing member 31 through the adhesive member 32.

The first backplate 30 and the second backplate 33 may have the same thickness. Alternatively, the first backplate 30 and the second backplate 33 may have different thicknesses. However, embodiments of the present disclosure are not limited thereto.

Each of the first backplate 30 and the second backplate 33 may have a strength and a thickness equal to or greater than a certain value to supplement the rigidity of the display panel 10'. Since the first backplate 30 is formed to have a certain strength and thickness to supplement the rigidity of the display panel 10', the first backplate may not be formed in the bent area BA in which the display panel 10' is bent to have a curved shape. Embodiments of the present disclosure are not limited thereto.

Based on a shape of the display panel 10' before being bent, the second backplate 33 may be disposed under the display panel 10' so as to be spaced apart from the first backplate 30. The second backplate 33 may be disposed under the display panel 10' to supplement the rigidity of the display panel 10' and to maintain the display panel 10' in a flat state. Since the second backplate 33 is formed to have a certain strength and thickness to supplement the rigidity of the display panel 10', the second backplate may not be formed in the bent area BA in which the display panel 10' is bent to have a curved shape. Embodiments of the present disclosure are not limited thereto.

The fixing member 31 may support a plane of the display panel 10' while being disposed between the first backplate 30 and the second backplate 33. The fixing member 31 may include, for example, a metal to reinforce a supporting force of the first backplate 30 and the second backplate 33. Furthermore, the fixing member 31 may be made of a plastic material including at least one of polycarbonate (PC), polyimide (PI), polyethylene naphthalate (PEN), and polyethylene terephthalate (PET). Embodiments of the present disclosure are not limited thereto. Alternatively, the fixing member 31 may include one or a combination of stainless steel (SUS), glass, ceramic, and metal.

The bent area BA of the display panel 10' may include an area where the partitioning wall 940 is disposed, and the bent protective layer 34 may be disposed to overlap the partitioning wall 940. The bent protective layer 34 may include a polymer material and may prevent moisture penetration into the bent area BA.

The bent protective layer 34 may be disposed on an outer surface of the display panel 10' and in the bent area BA. The bent protective layer 34 may improve deformation of the display panel 10' in the bent area BA and may allow the display panel 10' to be bent at a constant curvature. The bent protective layer 34 may be embodied as a resin layer to compensate for weakening of the rigidity of the display panel caused by bending of the display panel 10' in the bent area BA. Furthermore, the bent protective layer 34 may be made of a polymer such as polyimide (PI) or polyethylene terephthalate (PET). When the bent protective layer 34 is embodied as a polymer film, the bent protective layer may have a modulus of about 1 to about 10 GPa. Embodiments of the present disclosure are not limited thereto.

The bent protective layer 34 may include resin, for example, ultraviolet (UV) ray curable acryl resin. However, the present disclosure is not limited thereto. Specifically, the bent protective layer 34 may be made of a cured product of a resin obtained by coating the resin and curing the same. When the resin is the ultraviolet ray curable resin, the resin may be cured using ultraviolet rays.

The bent protective layer 34 may be disposed on the outer surface of the bent portion of the display panel 10' so as to cover various signal lines between a pad of the display panel 10' and an encapsulation portion. Therefore, the bent protective layer 34 may prevent moisture penetration into the signal line while protecting the signal line from external shock.

Furthermore, the bent protective layer 34 may be disposed on the outer surface of the display panel 10' in the bent area BA and thus may supplement the rigidity of the display panel 10' in the bent area BA where the support member has been removed. The bent protective layer 34 may include, for example, a micro coating layer. The micro coating layer (MCL) may be referred to as a micro cover layer (MCL).

The data driver D-IC may be disposed under the bended portion of the display panel 10' in the non-display area NA. The data driver D-IC may supply the data voltage to the display panel 10'.

As shown in FIG. 3, the display panel 10' may include the display area AA, the non-display area NA, the bent area BA, and the light-emitting element EL to be described later.

A cover window 80 may be disposed on top of the display panel 10'.

The cover window 80 may include an optical film 81, an adhesive 82, and an upper substrate 83. The optical film 81 may include a polarizing film (POL). Embodiments of the present disclosure are not limited thereto. The adhesive 82 may include at least one layer and may be made of at least one of OCA (Optical Clear Adhesive), OCR (Optical Clear Resin), or a pressure sensitive adhesive (PSA).

The upper substrate 83 may be disposed on the display panel 10' in the display area AA. The upper substrate 83 may extend such that an end thereof is disposed outwardly beyond a bent end PE of the display panel 10'. A black ink 84 may be applied on the upper substrate 83 in an aera corresponding to the non-display area NA of the display panel 10' to prevent light leakage.

Although not shown in the drawing, the display device 10 according to an embodiment of the present disclosure may include the gate driver GIP that supplies the gate signal to the display panel 10', and a controller T-Con that controls the gate driver GIP and the data driver D-IC.

As shown in FIG. 4, in the display device 10 according to an embodiment of the present disclosure, the optical film 81 may be disposed on the display panel 10', the upper substrate 83 may be disposed on the optical film 81 through an adhesive 82, the first backplate 30 may be disposed under the display panel 10', the fixing member 31 may be disposed under the first backplate 30, the second backplate 33 may be disposed under the fixing member 31 through the adhesive member 32, the bent portion of the display panel 10' may be disposed under the second backplate 33, and the bent protective layer 34 may be disposed under the bent portion of the display panel 10'.

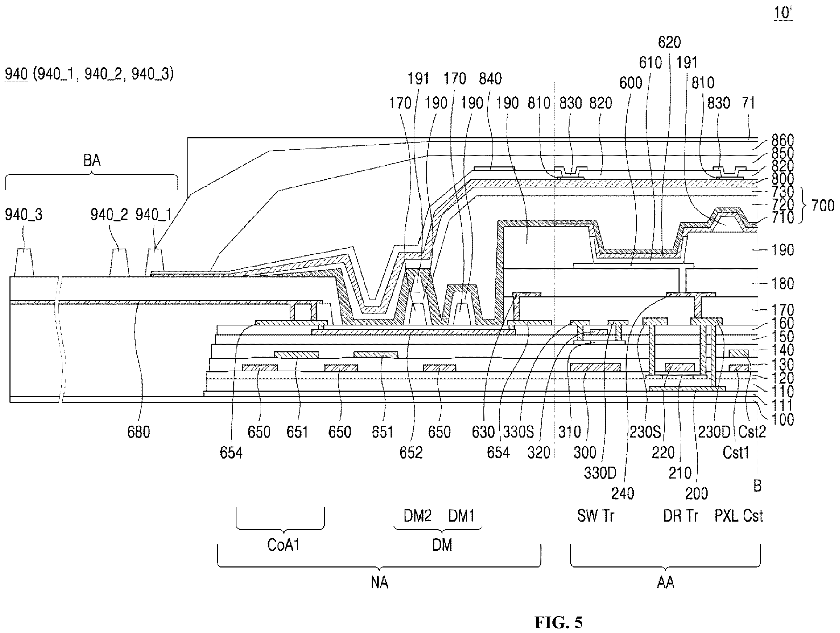

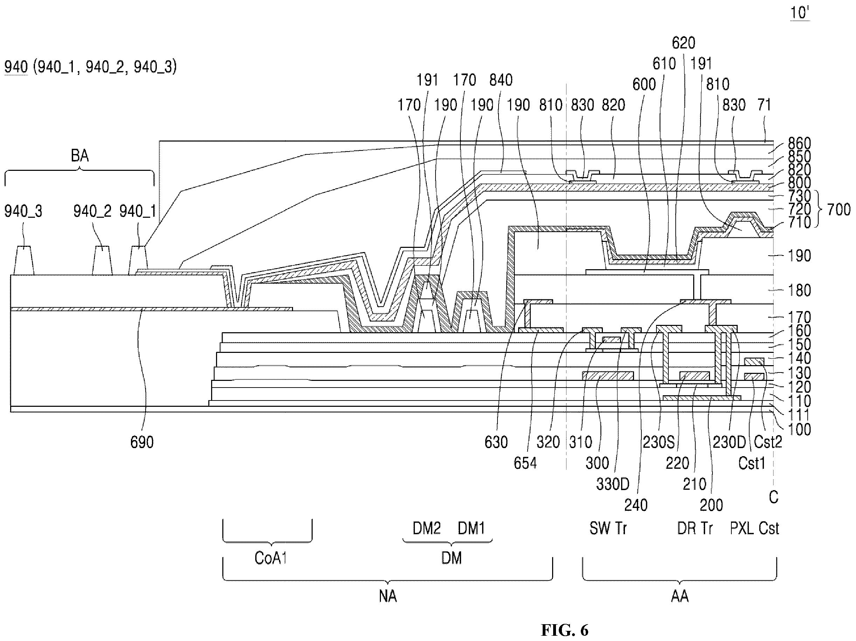

FIG. 5 is a cross-sectional view of a display panel according to an embodiment of the present disclosure as cut along a line B-B' in FIG. 3, and FIG. 6 is a cross-sectional view of a display panel according to an embodiment of the present disclosure as cut along a line C-C' in FIG. 3.

FIG. 5 and FIG. 6 show a flat state of the display panel 10' before it is bent, and schematically show the data line for transmitting the data signal to each pixel.

The substrate 100 of the display device according to an embodiment of the present disclosure may be composed of a first substrate and a second substrate, and an intermediate layer between the first substrate and the second substrate.

Each of the first substrate and the second substrate may be made of at least one of polyimide, polyethersulfone, polyethylene terephthalate, and polycarbonate. Embodiments of the present disclosure are not limited thereto. When the substrate is made of a plastic material, a manufacturing process of the display device proceeds while a support substrate made of glass is disposed under the substrate. The support substrate may be released therefrom after the manufacturing process of the display device has been completed. Furthermore, after the support substrate has been released, a backplate (or a plate) for supporting the substrate may be disposed under the substrate. When the substrate is made of a plastic material, moisture may penetrate the substrate and travel to the thin film transistor or light-emitting element layer, thereby deteriorating the performance of the display device. The display device according to an embodiment of the present disclosure may include two substrates, that is, the first substrate and the second substrate made of the plastic material to prevent the performance of the display device from being deteriorated due to the moisture permeation. Further, the inorganic intermediate layer may be disposed between the first and second substrates such that he performance reliability of the product may be improved by preventing the moisture from penetrating the substrate. The intermediate layer may be made of an inorganic material. For example, the intermediate layer may be composed of a single layer or a multilayer made of silicon nitride (SiNₓ) or silicon oxide (SiOₓ). However, the present disclosure is not limited thereto.

The display device including the substrate 100 may include a plurality of areas. The areas may include the display area AA and the non-display area NA. However, the present disclosure consists of is not limited thereto.

A buffer layer 111 composed of a single layer or multiple layers made of silicon nitride (SiNₓ) or silicon oxide (SiOₓ) may be disposed in the display area AA and the non-display area NA and on one surface of the substrate 100. The buffer layer 111 may improve the adhesion between the layers formed on the buffer layer 111 and the substrate 100 and block various types of defect factors such as alkaline components leaking from the substrate 100. Furthermore, the buffer layer 111 may delay the diffusion of moisture or oxygen that has penetrated the substrate 100.

The buffer layer 111 may be omitted based on a type and a material of the substrate, a structure and a type of the thin film transistor, etc.

The transistors in the display area AA may include a switching transistor ST1 or a driving transistor DT for driving the sub-pixel SP.

A light blocking layer 200 may be disposed under the driving transistor DT.

The light blocking layer 200 may be connected to a first drain electrode 230D of the driving transistor DT. The light blocking layer 200 may prevent light from being directed to a first semiconductor layer 210 of the driving transistor DT, and may be connected to the first drain electrode 230D to prevent a phenomenon in which parasitic carriers are accumulated in the first semiconductor layer 210, thereby causing a rapid increase in drain current, or a change in a threshold voltage due to this phenomenon.

The light blocking layer 200 may be composed of multiple layers including a first layer including titanium (Ti), which is the same material as a material of the first source electrode 230S and the first drain electrode 230D, and a second layer including at least one of molybdenum (Mo), copper (Cu), aluminum (Al), silver (Ag,) chromium (Cr), gold (Au), neodymium (Nd), and nickel (Ni). Embodiments of the present disclosure are not limited thereto.

A first insulating layer 110 may be disposed on the light blocking layer 200. The first insulating layer 110 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

The first semiconductor layer 210 of the driving transistor DT of the display area AA may be disposed on the first insulating layer 110, and the first semiconductor layer 210 may overlap the light blocking layer 200.

The first semiconductor layer 210 may be made of low temperature polycrystalline silicon (LTPS).

A first gate insulating layer 120 may be disposed on the first semiconductor layer 210. The first gate insulating layer 120 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A first gate electrode 220 may be disposed on the first gate insulating layer 120 so as to overlap with the first semiconductor layer 210.

The first gate electrode 220 may be made of at least one of silver (Ag,) molybdenum (Mo), copper (Cu), titanium (Ti), aluminum (Al), chromium (Cr), nickel (Ni), neodymium (Nd), tungsten (W), and gold (Au). Embodiments of the present disclosure are not limited thereto.

A first metal layer 300 overlapping a first switching transistor ST1, and a first capacitor electrode Cst1 of a capacitor Cst included in the sub-pixel SP may be disposed on the first gate insulating layer 120 in the display area AA. In the non-display area NA, a link wiring 650 may be disposed on the first gate insulating layer 120.

The first capacitor electrode Cst1, the first metal layer 300, and the link wiring 650 may be formed in the same process as a process in which the first gate electrode 220 is formed. The link wiring 650 may include the gate driving line GIPL as shown in FIG. 3.

The first metal layer 300 may be driven by a lower gate electrode of the first switching transistor ST1, or may be used as a light blocking layer that may prevent light from being reflected toward the second semiconductor layer 310 of the first switching transistor ST1. Embodiments of the present disclosure are not limited thereto.

A second insulating layer 130 may be disposed on the first gate electrode 220, the first capacitor electrode Cst1, the first metal layer 300, and the first link wiring 650.

The second insulating layer 130 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A second capacitor electrode Cst2 of the capacitor Cst may be disposed on the second insulating layer 130. The second capacitor electrode Cst2 may be disposed to overlap the first capacitor electrode Cst1 and may be made of the same material as a material of the first capacitor electrode Cst1.

A second link wiring 651 may be disposed in the non-display area and on the second insulating layer 130 and may be formed in the same process as a process in which the second capacitor electrode Cst2 is formed.

A third insulating layer 140 may be disposed on the second capacitor electrode Cst2.

The third insulating layer 140 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A second semiconductor layer 310 of the first switching transistor ST1 of the display area AA may be disposed on the third insulating layer 140.

The second semiconductor layer 310 may be made of a metal oxide semiconductor, such as indium-gallium-zinc-oxide (IGZO), indium-zinc-oxide (IZO), indium-gallium-tin-oxide (IGTO), and indium-gallium-oxide (IGO). However, the present disclosure is not limited thereto.

The metal oxide semiconductor may include a channel area where a channel through which electrons or holes migrate is formed, a source area, and a drain area.

For example, the conductive characteristics of the source and drain areas may be improved by a doping process that injects impurities. During an etching process to form the gate electrode on the metal oxide semiconductor, oxygen in an area of the metal oxide semiconductor that does not overlap with the gate electrode may be released to improve conductivity thereof such that the source and drain areas may become conductive. A source electrode and a drain electrode may be respectively connected to the source area and the drain area.

A second gate insulating layer 150 may be disposed on the second semiconductor layer 310, and a second gate electrode 320 may be disposed on the second gate insulating layer 150.

The second gate insulating layer 150 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

The second gate electrode 320 may be disposed on the second gate insulating layer 150 so as to overlap the second semiconductor layer 310.

The second gate electrode 320 may be composed of a single layer or a multi-layer made of one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

A third link wiring 652 may be disposed on the second gate insulating layer 150 in the non-display area NA.

The first link wiring 650, the second link wiring 651, and the third link wiring 652 may extend to the display area AA and may apply a signal or a power voltage to the display area AA. The first link wiring 650, the second link wiring 651, and the third link wiring 652 may be connected to each other via a contact hole. However, embodiments of the present disclosure are not limited thereto.

The third link wiring 652 may extend from the non-display area NA and be disposed to at least partially overlap the dam area DM in the non-display area NA.

A fourth insulating layer 160 may be disposed on the second gate electrode 320 and the third link wiring 652. The fourth insulating layer 160 may be made of an insulating inorganic material such as silicon nitride (SiNₓ) or silicon oxide (SiOₓ), or may be made of one or more organic insulating materials such as BCB (BenzoCycloButene), acryl resin, epoxy resin, phenolic resin, polyamide resin, or polyimide resin. However, embodiments of the present disclosure are not limited thereto.

A first source electrode 230S and a first drain electrode 230D connected to the first semiconductor layer 210, and a second source electrode 330S and a second drain electrode 330D connected to the second semiconductor layer 310 may be disposed on the fourth insulating layer 160.

The first source electrode 230S and the first drain electrode 230D are connected to the first semiconductor layer 210 via contact holes extending through the first gate insulating layer 120, the second insulating layer 130, the third insulating layer 140, the second gate insulating layer 150, and the fourth insulating layer 160.

The second source electrode 330S and the second drain electrode 330D are connected to the second semiconductor layer 310 via contact holes extending through the second gate insulating layer 150 and the fourth insulating layer 160.

A fourth link wiring 654 may be disposed on the fourth insulating layer 160 in the non-display area NA. The fourth link wiring 654 may be formed in the same process as a process in which the first source electrode 230S, the first drain electrode 230D, the second source electrode 330S, and the second drain electrode 330D are formed.

Each of the first source electrode 230S, the first drain electrode 230D, the second source electrode 330S, the second drain electrode 330D, and the fourth link wiring 654 may be made of at least one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

The link wirings between the dam area DM of the non-display area NA and the display area AA may be electrically connected to each other via contact holes. The fourth link wiring 654 may be electrically connected to a fifth link wiring 630 and the third link wiring 652. However, embodiments of the present disclosure are not limited thereto.

A plurality of contact holes may be formed in the first connection area CoA1 of the non-display area NA so as to connect the link wiring and a driving signal bent wiring 680 of the bent area BA to each other. In the first connection area CoA1, the first link wiring 650 and the fourth link wiring 654 may be connected to each other via a contact hole, or the second link wiring 651 may be connected to the fourth link wiring 654 via a contact hole, and the third link wiring 652 may be connected to the fourth link wiring 654 via a contact hole. However, embodiments of the present disclosure are not limited thereto.

A first planarization layer 170 may be disposed on the first source electrode 230S, the first drain electrode 230D, the second source electrode 330S, the second drain electrode 330D, and the fourth link wiring 654.

The first planarization layer 170 may be embodied as an organic insulating layer made of, for example, polyacrylate or polyimide, and may reduce a step caused by underlying wirings and contact holes.

Due to the bending curvature of the display panel 10' in the bent area BA, in the insulating film formed as the inorganic insulating film, cracks may occur. Thus, in the bent area BA, the inorganic insulating film may be vulnerable to moisture penetration. For this reason, the inorganic insulating film in the bent area BA vulnerable to moisture penetration may be entirely removed in an etching process.

When each of the buffer layer 111, the first insulating layer 110, the first gate insulating layer 120, the second insulating layer 130, the third insulating layer 140, the second gate insulating layer 150 and the fourth insulating layer 160 is embodied as the inorganic insulating film, each of the buffer layer 111, the first insulating layer 110, the first gate insulating layer 120, the second insulating layer 130, the third insulating layer 140, the second gate insulating layer 150 and the fourth insulating layer 160 may be removed in the bent area BA in an etching process and may not be disposed in the bent area BA.

A portion of the substrate 100 may be etched to control the bending curvature of the bent area BA.

During the etching process, ends of the insulating layers may not be aligned with each other in a vertical manner such that the insulating layers may be stacked in a stepwise manner. However, embodiments of the present disclosure are not limited thereto.

The first planarization layer 170 may be in contact with the ends of the insulating layers and the substrate 100 in the bent area BA.

A connection electrode 240 may be disposed on the first planarization layer 170 so as to connect the first drain electrode 230D and an anode electrode 600 to each other.

The connection electrode 240 may be electrically connected to the first drain electrode 230D via a contact hole formed in the first planarization layer 170.

On the first planarization layer 170, a fifth link wiring 630 and the driving signal bent wiring 680 of the first connection area CoA1 and the bent area BA may be disposed in the non-display area NA. The bent wiring 680 may be connected to the fourth link wiring 654 via a contact hole and may extend into the bent area BA so as to be electrically connected to the wirings of the pad wiring area PADA.

Each of the connecting electrode 240, the fifth link wiring 630, and the bent wiring 680 may be made of at least one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

A second planarization layer 180 may be disposed on the connection electrode 240, the fifth link wiring 630, and the driving signal bent wiring 680. The second planarization layer 180 may be embodied as an organic insulating layer made of, for example, polyacrylate or polyimide. Embodiments of the present disclosure are not limited thereto.

The second planarization layer 180 may be disposed on the first connection area CoA1 of the non-display area NA, and may be disposed on the driving signal bent wiring 680 in the bent area BA.

The light-emitting element EL may be disposed on the second planarization layer 180. The light-emitting element EL may include the anode electrode 600, a light-emitting layer 610, and a cathode electrode 620. Accordingly, the anode electrode 600 may be disposed on the second planarization layer 180.

The anode electrode 600 may be electrically connected to the connection electrode 240 via a through hole formed in the second planarization layer 180. The anode electrode 600 may be made of at least one of silver (Ag), aluminum (Al), gold (Au), molybdenum (Mo), tungsten (W), chromium (Cr), lead (Pd), indium tin oxide (ITO), indium zinc oxide (IZO), or an alloy thereof. Embodiments of the present disclosure are not limited thereto.

A bank 190 may be disposed on the anode electrode 600 and the second planarization layer 180.

The bank 190 may distinguish a plurality of sub-pixels from each other, minimize light blurring, and prevent color mixing that occurs at various viewing angles.

The bank 190 may not cover a portion of the anode electrode 600 corresponding to a light-emitting area so as to be exposed, and may overlap an end of the anode electrode 600. The bank 190 may be made of an insulating inorganic material such as silicon nitride (SiNₓ) or silicon oxide (SiOₓ), or may be made of one or more organic insulating materials such as BCB (BenzoCycloButene), acryl resin, epoxy resin, phenolic resin, polyamide resin, or polyimide resin. However, embodiments of the present disclosure are not limited thereto.

A spacer 191 may be further disposed on the bank 190. The spacer 191 may maintain a gap between the substrate 100 on which the light-emitting layer 610 has been formed and a touch unit and a cover window disposed on top thereof. Thus, When an external physical shock is applied thereto, damage to the elements inside the display panel may be minimized due to the gap. The spacer 191 may be made of the same material as a material of the bank 190, and may be formed in the same process as a process in which the bank 190 is formed. However, embodiments of the present disclosure are not limited thereto.

The light-emitting layer 610 may be disposed in an opening of the bank 190 exposing the portion of the anode electrode 600. The light-emitting layer 610 may include one or more of a red light-emitting layer, a green light-emitting layer, a blue light-emitting layer, and a white light-emitting layer in order to emit light of a specific color. Furthermore, the light-emitting layer 610 may further include a hole injection layer, a hole transport layer, an electron transport layer, and an electron injection layer in addition to the organic light-emitting layer. However, embodiments of the present disclosure are not limited thereto.

The hole injection layer, the hole transport layer, the electron transport layer, and the electron injection layer may be individually disposed in each of the sub-pixels and may have different thicknesses and materials. Alternatively, each of the hole injection layer, the hole transport layer, the electron transport layer, and the electron injection layer may be commonly disposed in an entirety of the display area.

When the light-emitting layer 610 includes the white organic light-emitting layer, the light-emitting layer 610 may be disposed in the opening of the bank 190 and across an entirety of the substrate.

A color filter may be disposed on the light-emitting layer 610 so as to convert light emitted from the white organic light-emitting layer into light of a different color other than white.

The cathode electrode 620 may be disposed on the light-emitting layer 610. The cathode electrode 620 may supply electrons to the light-emitting layer 610 and may be made of a conductive material with a low work function.

When the display device 10 operates in a top light emission scheme, the cathode electrode 620 may be made of a transparent conductive material that transmits light therethrough. For example, the cathode electrode 620 may be made of at least one of indium tin oxide (ITO) and indium zinc oxide (IZO). However, embodiments of the present disclosure are not limited thereto.

Alternatively, the cathode electrode 620 may be made of a translucent conductive material that transmits light therethrough. For example, the cathode electrode 620 may be made of at least one of following alloys: LiF/Al, CsF/Al, Mg:Ag, Ca/Ag, Ca:Ag, LiF/Mg:Ag, LiF/Ca/Ag, and LiF/Ca:Ag. However, embodiments of the present disclosure are not limited thereto.

When the display device 10 operates in a bottom light emission scheme, the cathode electrode 620 may be embodied as a reflective electrode that reflects light and may be made of an opaque conductive material. For example, the cathode electrode 620 may be made of at least one of silver (Ag), aluminum (Al), gold (Au), molybdenum (Mo), tungsten (W), chromium (Cr), or alloys thereof. However, embodiments of the present disclosure are not limited thereto.

In the non-display area NA, a driver circuit area and the dam area DM where a plurality of dams are disposed may be disposed.

The dam area DM may be an area where the driver circuit area of the display panel 10' and the pixel area PXL of the display area AA are sealed.

The dam area DM may include a plurality of dams such as a first dam DM1 and a second dam DM2.

The first dam DM1 may be deposited using the same material as that of each of the first planarization layer 170 and the bank 190, and in the same process as a process in which each of the first planarization layer 170 and the bank 190 is formed. The second dam DM2 may be deposited using the same material as that of each of the first planarization layer 170, the bank 190 and the spacer 191, and in the same process as a process in which each of the first planarization layer 170, the bank 190, and the spacer 191 is formed. However, embodiments of the present disclosure are not limited thereto.

The first dam DAM1 and the second dam DAM2 may have a first height and a second height, respectively, and may surround the display area AA.

The second dam DAM2 may be higher than the first dam DAM1. The second height may be larger than the first height. Although a second encapsulation layer 720 of an encapsulation layer 700, which will be described later extends over the first dam DM1 of the dam area DM, a second encapsulation layer 720 may not extend beyond the second dam DM2 in the dam area DM and may be blocked by the second dam DM2.

The first encapsulation layer 710 and the third encapsulation layer 730 of the encapsulation layer 700 may extend over the second dam DM2 to an outside area out of the dam area DM and may be disposed on the second planarization layer 180 in the first connection area CoA1.

The encapsulation layer 700 may be disposed on a portion of the cathode electrode 620 of the display area AA, a portion of the cathode electrode 620 of the non-display area NA, and the second dam DM2.

The encapsulation layer 700 may protect the display device 10 from external moisture, oxygen, or foreign substances. For example, the encapsulation layer 700 may prevent oxygen and moisture from penetrating from the outside into the display device to prevent oxidation of the light-emitting material and the electrode material.

The encapsulation layer 700 may be made of a transparent material to transmit light emitted from the light-emitting layer 610 therethrough.

The encapsulation layer 700 may be disposed on the light-emitting element EL of one pixel in the display area AA. The encapsulation layer 700 may include the first encapsulation layer 710, the second encapsulation layer 720, and the third encapsulation layer 730 that block the penetration of moisture or oxygen. However, embodiments of the present disclosure are not limited thereto. The first encapsulation layer 710, the second encapsulation layer 720, and the third encapsulation layer 730 may be sequentially stacked. However, embodiments of the present disclosure are not limited thereto.

Each of the first encapsulation layer 710 and the third encapsulation layer 730 may be made of at least one inorganic material selected from silicon nitride (SiNₓ), silicon oxide (SiOₓ), or aluminum oxide (Al_{y}O_{z}). However, embodiments of the present disclosure are not limited thereto.

The second encapsulation layer 720 may cover foreign substances or particles that may be produced during the manufacturing process. Furthermore, the second encapsulation layer 720 may planarize a surface step of the first encapsulation layer 710.

The second encapsulation layer 720 may be made of an organic material such as silicon oxycarbide (SiOC), epoxy, polyimide, polyethylene, or acrylate-based polymer. However, embodiments of the present disclosure are not limited thereto.

A touch buffer layer 800 may be disposed on the third encapsulation layer 730. The touch buffer layer 800 may be disposed across an entirety of the display area AA and the non-display area NA, and may extend into a portion of the bent area BA.

The touch buffer layer 800 may be made of at least one inorganic material selected from silicon nitride (SiNₓ), silicon oxide (SiOₓ), or aluminum oxide (Al_{y}O_{z}). However, embodiments of the present disclosure are not limited thereto.

A touch electrode 810 and 830 may be disposed on the encapsulation layer 700 in the display area AA, and the touch electrode 810 and 830 may include the first touch electrode 810 and the second touch electrode 830.

The touch buffer layer 800 may be disposed on the encapsulation layer 700, the first touch electrode 810 may be disposed on the touch buffer layer 800, a touch insulating layer 820 may be disposed on the touch buffer layer 800 and the first touch electrode 810, and the second touch electrode 830 may be disposed on the touch insulating layer 820.

Touch operation may be achieved by a plurality of sensing electrodes and a plurality of driving electrodes disposed in the display area AA. Each of the sensing electrodes may include a plurality of sub-sensing electrodes which extend along a first direction and are spaced from each other by a regular spacing along a second direction. The plurality of sensing electrodes may not break but may extend continuously in the first direction. The first direction and the second direction may intersect each other. For example, the first direction and the second direction may be perpendicular to each other.

Each of the plurality of driving electrodes may include a plurality of sub-driving electrodes which extend along the second direction and are spaced from each other by a regular spacing along the first direction. The plurality of sub-driving electrodes may be electrically connected to each other in the second direction.

When the plurality of sub-sensing electrodes and the plurality of sub-driving electrodes are formed in the same layer, the plurality of sub-driving electrodes may be electrically connected to each other through a bridge pattern. The plurality of sub-sensing electrodes and the plurality of sub-driving electrodes may have a metal mesh structure.

Additionally, the plurality of sub-sensing electrodes may be electrically connected to each other through a bridge pattern, and the plurality of sub-driving electrodes may not break but may extend continuously and may be electrically connected to each other.

The first touch electrode 810 may act as the plurality of sub-sensing electrodes, the plurality of sub-driving electrodes, or the bridge pattern.

The first touch electrode 810 may have a single-layer or multi-layer structure made of a metal material such as molybdenum (Mo), silver (Ag), titanium (Ti), copper (Cu), aluminum (Al), titanium/aluminum/titanium (Ti/Al/Ti), or molybdenum/ aluminum/molybdenum (Mo/Al/Mo). However, embodiments of the present disclosure are not limited thereto.

The touch insulating layer 820 may be disposed on the first touch electrode 810. The touch insulating layer 820 may be disposed across an entirety of the display area AA and non-display area NA, and may be disposed so as to extend into a portion of the bent area BA.

The touch insulating layer 820 may be made of at least one inorganic material selected from silicon nitride (SiNₓ), silicon oxide (SiOₓ), or aluminum oxide (Al_{y}O_{z}). However, embodiments of the present disclosure are not limited thereto.

The second touch electrode 830 may be disposed on the touch insulating layer 820. The second touch electrode 830 may act as the plurality of sub-sensing electrodes, the plurality of sub-driving electrodes, or the bridge pattern for touch operation.

In the same process as a process in which the second touch electrode 830 is formed, a touch signal line 840 for transmitting a touch driving signal to the non-display area NA may be formed on the touch insulating layer 820. The touch signal line 840 may include the same material as a material of the touch electrode 810 and 830.

Each of the second touch electrode 830 and the touch signal line 840 may have a single-layer or multi-layer structure made of a metal material such as molybdenum (Mo), silver (Ag), titanium (Ti), copper (Cu), aluminum (Al), titanium/aluminum/titanium (Ti/Al/Ti), or molybdenum/ aluminum/molybdenum (Mo/Al/Mo). However, embodiments of the present disclosure are not limited thereto.

A third planarization layer 850 may be disposed on the second touch electrode 830 and the touch signal line 840.

The third planarization layer 850 may cover the second touch electrode 830, the touch signal line 840, and the touch insulating layer 820 and may perform planarization thereon. Furthermore, the third planarization layer 850 may be made of one or more organic insulating materials such as BCB (BenzoCycloButene), acryl resin, epoxy resin, phenolic resin, polyamide resin, or polyimide resin. However, embodiments of the present disclosure are not limited thereto.

The partitioning wall 940 may be disposed in the bent area BA. The partitioning wall 940 may be formed in the same process as a process in which the third planarization layer 850 is formed, and may be disposed on the second planarization layer 180. The partitioning wall 940 may include a first partitioning wall 940_1, a second partitioning wall 940_2, and a third partitioning wall 940_3. The first partitioning wall 940_1 and the second partitioning wall 940_2 may be disposed in an area adjacent to the display area, and the third partitioning wall 940_3 may be disposed in an area adjacent to the pad wiring area PADA.

The first partitioning wall 940_1 may overlap and cover an end of each of the touch buffer layer 800 and the touch insulating layer 820 extending into a portion of the bent area BA.

The touch buffer layer 800 and the touch insulating layer 820 may extend beyond an end of each of the buffer layer 111, the first insulating layer 110, the first gate insulating layer 120, the second insulating layer 130, the third insulating layer 140, the second gate insulating layer 150, and the fourth insulating layer 160 disposed under the first planarization layer 170 and then may extend into the bent area BA.

External moisture may penetrate through the contact hole formed in the first connection area CoA1 of the bending area BA. Such moisture penetration may cause corrosion of the wiring of the first connection area CoA1 and reduce the reliability of the display device 10.

Since the touch buffer layer 800 and the touch insulating layer 820 may be disposed to extend into the bent area BA, an external moisture infiltration path may further extend into the bent area BA such that the moisture infiltration into the light emission area and the electrode area may be reduced.

A protective layer 860 may be disposed on the third planarization layer 850. The protective layer 860 may protect the display panel 10' from foreign substances or particles and may planarize the surface step of the display panel 10'. The protective layer 860 may be made of an organic material, for example, silicon oxycarbide (SiOC), or epoxy, polyimide, polyethylene, or acrylate-based polymer. However, the present disclosure is not limited thereto.

The protective layer 860 may extend beyond the third planarization layer 850 and may be disposed in a portion of the bent area BA. The first partitioning wall 940_1 and the second partitioning wall 940_2 may prevent the protective layer 860 from extending into an area where the display panel 10' is substantially bent in the bent area BA.

An adhesive layer 71 for attaching the display panel 10' and the cover window 80 to each other may be disposed on the protective layer 860.

FIG. 6 is a cross-sectional view of a display panel according to an embodiment of the present disclosure as cut along line C-C' in FIG. 3, and schematically shows the touch signal line 840 for transmitting the touch signal.

When describing the components in FIG. 6, descriptions of the components that are the same as or correspond to the components in FIG. 5 will be omitted or simplified.

The touch signal line 840 may extend to the non-display area NA while being disposed on the touch insulating layer 820 so as to overlap the dam area DM, and so as to be electrically connected to a touch bent wiring 690 in the first connection area CoA1.

A contact hole may extend through the second planarization layer, the touch buffer layer 800, and the touch insulating layer 820 in the first connection area CoA1, so that the touch signal line 840 and the touch bent wiring 690 may be connected to each other via the contact hole.

The touch bent wiring 690 may be formed in the same layer as a layer of the driving signal bent wiring 680 in FIG. 5, and may be formed in the same process as a process in which the driving signal bent wiring 680 in FIG. 5 is formed.

The touch buffer layer 800 and the touch insulating layer 820 may extend beyond an end of the touch signal line 840 toward the bent area BA and may be disposed to overlap the first partitioning wall 940_1.

An end of the touch signal line 840 may overlap the third planarization layer 850.

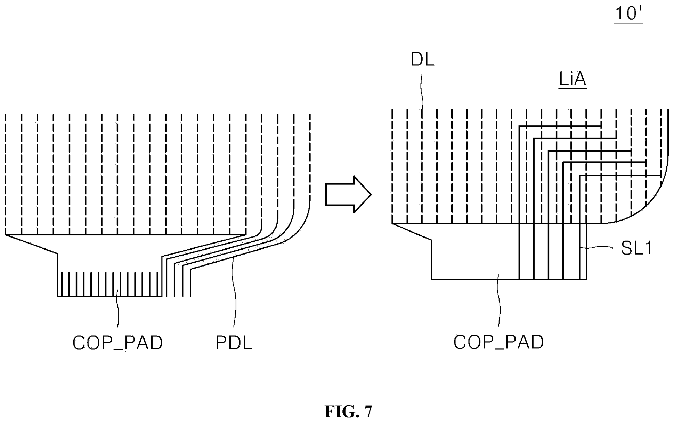

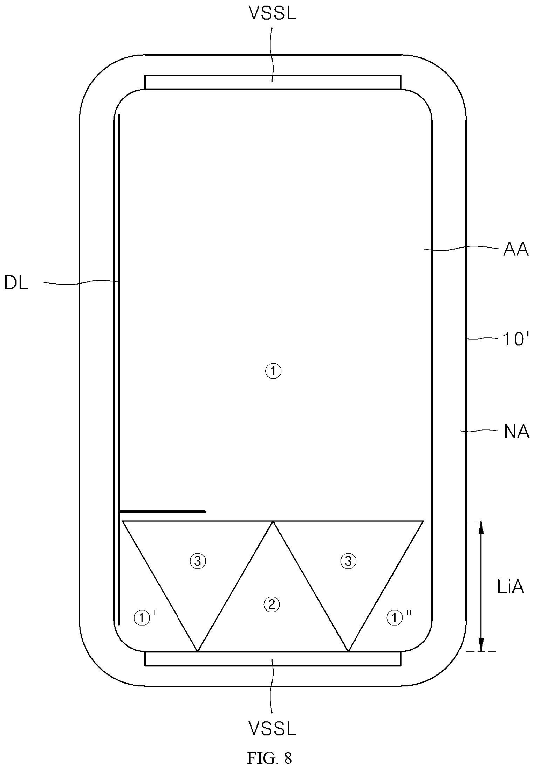

FIG. 7 is a diagram showing a display area including a link area LiA in the display panel according to an embodiment of the present disclosure, and FIG. 8 is an example of dividing the display area into areas according to an embodiment of the present disclosure.

Referring to FIG. 7, the display panel 10' according to an embodiment of the present disclosure may include the link area LiA adjacent to the second pad COP_PAD in the display area AA.

In this regard, the link area LiA refers to an area where a data link line intersects a portion of a first wiring SL1 in the display area AA, and may be disposed in a lower portion of the display area AA.

In this regard, the second pad COP_PAD may be disposed under the data driver D-IC in the non-display area NA as shown in FIG. 2 and may be electrically connected to the data driver D-IC. Therefore, the link area LiA may be disposed adjacent to the data driver D-IC in the display area AA.

In a conventional display panel, fan-out data lines PDL may extend from the second pad COP_PAD to the data wirings of the display area, respectively, for example, in a fan shape.

However, the fan-out data lines according to an embodiment of the present disclosure may extend such that at least one first wiring SL1 extends in a column direction in the non-display area and is disposed between the data wirings DL and extends into the display area AA, and is bent so as to extend in a row direction in the display area AA to overlap or intersect with a plurality of data wirings DL extending in the column direction.

Referring to FIG. 8, the display area AA according to an embodiment of the present disclosure may include a first area ① where at least one pixel PX is disposed, and the link area LiA other than the first area.

The link area LiA may include a (1-1)-th area ①' located on a lower portion of one of both opposing sides in the row direction of the display area AA, and a (1-2)-th area ①" located on a lower portion of the other of both opposing sides in the row direction of the display area AA. For example, the link area LiA may include the (1-1)-th area ①' located on the lower portion of the left side of the display area AA, and the (1-2)-th area ①" located on the lower portion of the right side of the display area AA.

The link area LiA may further include a second area ② and a third area ③. For example, the link area LiA may include the second area 20 and the third area ③ defined between the (1-1)-th area ①' and the (1-2)-th area CD".

The second area ② and the third area ③ may be located adjacent to each other. Each of the second area ② and the third area ③ may have a triangular shape. When the second area ② has a triangular shape, the third area ③ may have an inverted triangle shape.

In the link area LiA, the (1-1)-th area ①' and the (1-2)-th area ①" may be disposed adjacent to both separate third areas ③, respectively. That is, one of the both separate third areas ③ is defined between the (1-1)-th area ①' and the second area ②, while the other of the both separate third areas ③ is defined between the (1-2)-th area ①" and the second area ②.

The data wiring DL may extend downward in the column direction from the first area ① of the display area AA to the link area LiA. The data wiring DL may extend downward in the column direction and then be bent to extend in the row direction at a position upwardly adjacent to the link area LiA.

For example, the low-potential power wiring VSSL may be disposed in each of upper and lower ends of the non-display area NA of the display panel 10'. At least one low-potential power wiring VSSL may supply a low-potential power to the display panel 10'. For example, the at least one low-potential power wiring VSSL may respectively supply the low-potential power to the at least one pixel PX disposed in the display panel 10'.

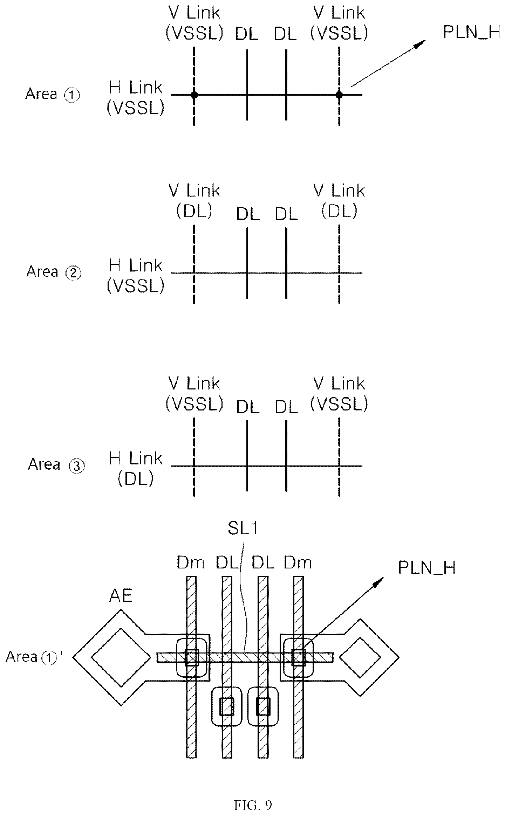

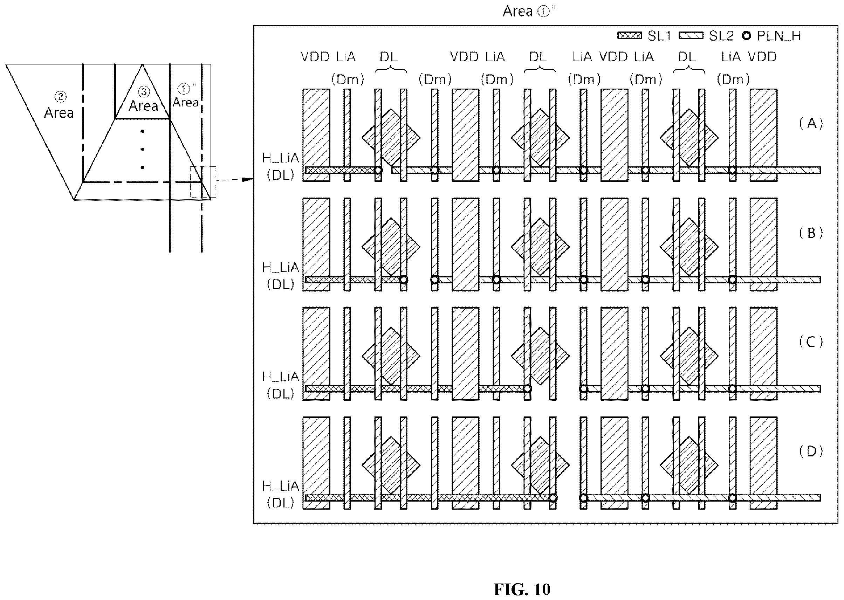

FIG. 9 is a diagram showing an example of a wiring arrangement in the first area ①, the (1-1)-th area ①', the second area ②, and the third area ③ of the display area according to an embodiment of the present disclosure. FIG. 10 is a diagram showing an example of a wiring arrangement in the (1-2)-th area ①" of the display area according to an embodiment of the present disclosure.

At least one first wiring SL1 disposed in the display area AA according to an embodiment of the present disclosure may include, for example, a low-potential power supply horizontal wiring H Link (VSSL) or a data power supply horizontal wiring H Link (DL).

Referring to FIG. 9 and FIG. 10, the at least one first wiring SL1 may be connected to at least one data wiring DL or at least one power wiring VSSL via a planar hole PLN_H in the first area ①, the (1-1)-th area ①', and the (1-2)-th area CD".

In the first area ①, the low-potential power supply horizontal wiring H Link (VSSL) may intersect the low-potential power supply vertical wiring V Link (VSSL) and the data wiring DL extending in the column direction. In this regard, the low-potential power supply horizontal wiring H Link (VSSL) may be electrically connected to the low-potential power supply vertical wiring V Link (VSSL) via the planar hole PLN_H.

In the second area ② and the third area ③, the low-potential power supply horizontal wiring H Link (VSSL) may intersect a data power supply vertical wiring V Link (DL) and the data wirings DL extending in the column direction. In this regard, the low-potential power supply horizontal wiring H Link (VSSL) may not be electrically connected to each of the data power supply vertical wiring V Link (DL) and the data wiring DL via the planar hole PLN_H.

In the (1-1)-th area ①', one first wiring SL1 may intersect dummy wirings Dm and data wirings DL extending in the column direction. In this regard, one first wiring SL1 may not be electrically connected to the data wirings DL. However, one first wiring SL1 may be electrically connected to each of the dummy wirings Dm via the planar hole PLN_H. Additionally, the anode electrode AE adjacent to the planar hole PLN_H may extend to the planar hole PLN_H and entirely cover the planar hole PLN_H.

One pixel PX of at least one or more pixels disposed in the display area AA may include the anode electrode 600, the light-emitting layer 610, and the cathode electrode 620 as described in FIG. 5. One pixel may be referred to as the light-emitting element EL.

The anode electrode AE adjacent to the planar hole PLN_H may extend into the planar hole PLN_H so as to cover the planar hole PLN_H and may contact at least one data wiring DL or at least one power wiring VSSL.

Referring to FIG. 10, in the (1-2)-th area ①" of the link area LiA, the first wiring SL1 as a data voltage supply horizontal wiring H_LiA (DL) may extend in the row direction so as to intersect a power wiring VDD, a dummy LiA wiring Dm, and a data wiring DL extending in the column direction. In this regard, the first wiring SL1 may be electrically connected to one data wiring DL via the planar hole PLN_H (A). Furthermore, a second wiring SL2 may extend in the row direction to intersect a plurality of data wirings DL, a plurality of power wirings VDD, and a plurality of dummy LiA wirings Dm extending in the column direction. In this regard, the second wiring SL2 may be electrically connected only to each dummy LiA wiring Dm via the planar hole PLN_H (A).

Furthermore, the first wiring SL1 as the data voltage supply horizontal wiring H_LiA (DL) may extend in the row direction to intersect with the power wiring VDD, the dummy LiA wiring Dm, and the plurality of data wirings DL extending in the column direction. In this regard, the first wiring SL1 may be electrically connected to the data wiring DL disposed at an end via the planar hole PLN_H (B). Furthermore, the second wiring SL2 may extend in the row direction to intersect the plurality of data wirings DL, the plurality of power wirings VDD, and the plurality of dummy LiA wirings Dm extending in the column direction. In this regard, the second wiring SL2 may be electrically connected only to each dummy LiA wiring Dm via the planar hole PLN_H (B).

Furthermore, the first wiring SL1 as the data voltage supply horizontal wiring H_LiA (DL) may extend in the row direction so as to intersect the plurality of power wirings VDD, the plurality of dummy LiA wirings Dm, and the plurality of data wirings DL extending in the column direction. In this regard, the first wiring SL1 may be electrically connected to the data wiring DL disposed at an end via the planar hole PLN_H (C). Furthermore, the second wiring SL2 may extend in the row direction to intersect the plurality of data wirings DL, the plurality of power wirings VDD, and the plurality of dummy LiA wirings Dm extending in the column direction. In this regard, the second wiring SL2 may be electrically connected only to each dummy LiA wiring Dm via the planar hole PLN_H (C).

Furthermore, the first wiring SL1 as the data voltage supply horizontal wiring H_LiA (DL) may extend in the row direction so as to intersect the plurality of power wirings VDD, the plurality of dummy LiA wirings Dm, and the plurality of data wirings DL extending in the column direction. In this regard, the first wiring SL1 may be electrically connected to the data wiring DL disposed at an end via the planar hole PLN_H (D). Furthermore, the second wiring SL2 may extend in the row direction to intersect the plurality of data wirings DL, the plurality of power wirings VDD, and the plurality of dummy LiA wirings Dm extending in the column direction. In this regard, the second wiring SL2 may be electrically connected only to each dummy LiA wiring Dm via the planar hole PLN_H (D).

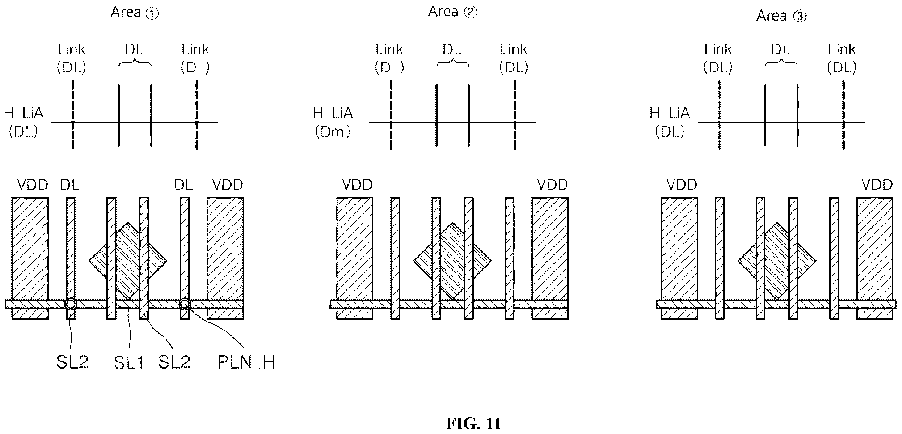

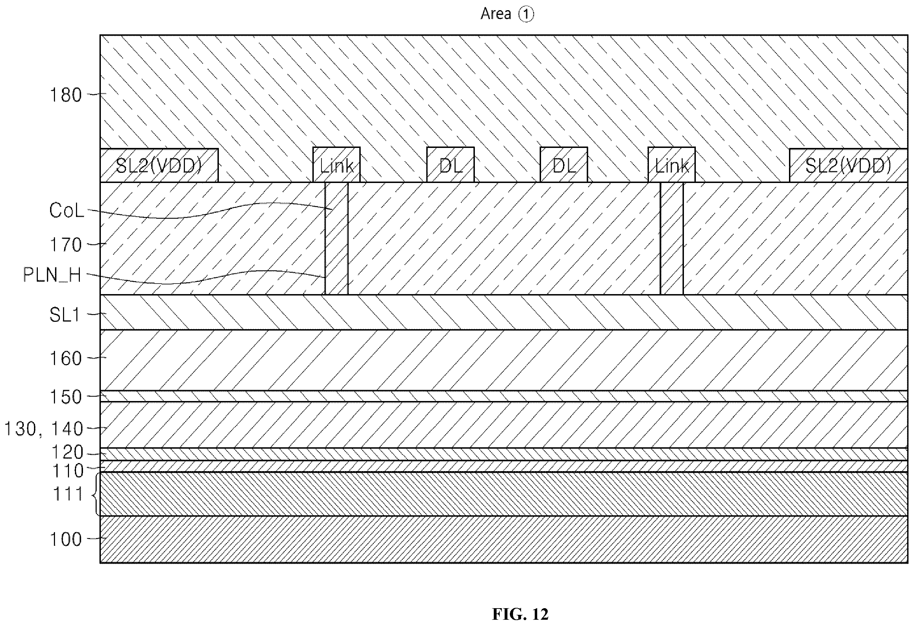

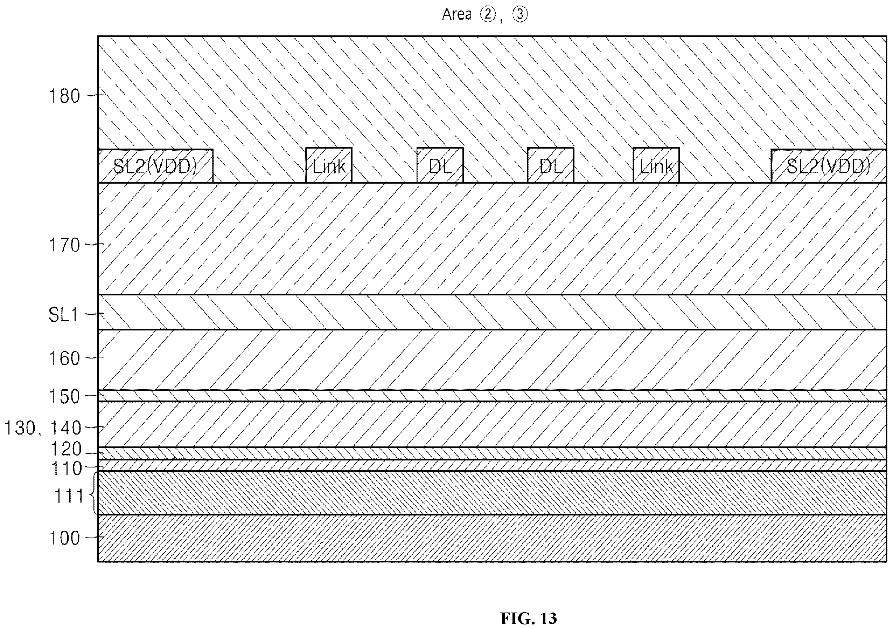

FIG. 11 is a diagram showing a line layout in the first to third areas of the link area according to an embodiment of the present disclosure. FIG. 12 is a diagram showing a line layout in the first area of the link area according to an embodiment of the present disclosure. FIG. 13 is a diagram showing a line layout in the second and third areas of the link area according to an embodiment of the present disclosure.

Referring to FIG. 11, in the first area ① according to an embodiment of the present disclosure, a plurality of data voltage supply link lines Link (DL) and a data wiring DL may extend in the column direction, while the first wiring SL1 as a horizontal line H_LiA (DL) may extend in the row direction so as to intersect the plurality of data voltage supply link lines Link (DL) and the data wiring DL. A plurality of power lines VDD may extend in the column direction. In this regard, the plurality of power lines VDD, and the link lines Link (DL), and the data wiring DL may be embodied as the second wirings SL2. Therefore, the first wiring SL1 extending in the row direction so as to intersect the plurality of power lines VDD, the link line Links (DL), and the data wiring DL may be electrically connected to the second wiring SL2 of the data wiring DL via the planar hole PLN_H.

Referring to FIG. 12, in the first area ① having the above line layout, the buffer layer 111 may be disposed on the substrate 100, the first insulating layer 110 may be disposed on the buffer layer 111, and the first gate insulating layer 120 may be disposed on the first insulating layer 110.

Furthermore, the second insulating layer 130 and the third insulating layer 140 may be disposed on the first gate insulating layer 120. The second gate insulating layer 150 may be disposed on the second insulating layer 130 and the third insulating layer 140. Th fourth insulating layer 160 may be disposed on the second gate insulating layer 150. The second insulating layer 130 may be an interlayer insulating layer ILD, the third insulating layer 140 may be the buffer layer O-BUF, and the fourth insulating layer 160 may be the second interlayer insulating layer O-II,D.

Furthermore, the first wiring SL1 may be disposed on the fourth insulating layer 160, the first planarization layer 170 may be disposed on the first wiring SL1, and the plurality of power supply second wirings SL2 (VDD), the link line Link, and the data wiring DL may be disposed on the first planarization layer 170.

The second planarization layer 180 may be disposed on the plurality of power supply second wirings SL2 VDD, the link line Link, and the data wiring DL.

In the first area ①, the planar hole PLN_H may be formed on each of the plurality of link lines Link and may be defined in the first planarization layer 170, and a connection line CoL may be formed in the planar hole PLN_H.

Therefore, in the first area ①, each of the plurality of link lines Links disposed on the first planarization layer 170 may be electrically connected to the first wiring SL1 via the connection line CoL filling the planar hole PLN_H.

As described above, the at least one first wiring SL1 may be respectively connected to at least one data wiring DL or at least one power wiring VSSL via the connection line CoL filling the planar hole PLN_H in the first area ①, the (1-1)-th area ①', and the (1-2)-th area ①".

However, referring again to FIG. 11, in the second area ② and the third area (3), the first wiring SL1 extending in the row direction so as to intersect the plurality of power lines VDD, the link lines Link (DL), and the data wiring DL extending in the column direction is not connected to the data wiring DL and the second wiring SL2 via the planar hole PLN_H.

Referring to FIG. 13, in the second area ② and the third area ③ according to an embodiment of the present disclosure, the first planarization layer 170 may be disposed on the first wiring SL1, and the planar hole PLN_H is not formed in the planarization layer 170.

Therefore, in the second area ② and the third area ③, any of the plurality of power supply second wirings SL2 (VDD), the link lines Link, and the data wiring DL disposed on the first planarization layer 170 may not be connected to the first wiring SL1.

The display device according to an embodiment of the present disclosure may realize slimming of the bezel area at a lower corner of the display area by placing the data link so as to extend across the display area of the display panel.

Furthermore, in the display device according to an embodiment of the present disclosure, the anode electrode may extend into the area in which the data link meets with the normal area of the display area so as to cover and fill the planar hole, thereby reducing the density difference due to the planar hole. Therefore, the display device according to an embodiment of the present disclosure may implement a narrow bezel in addition to improving a yield.

Furthermore, in the display device according to an embodiment of the present disclosure, the appearance defect due to the density difference due to the planar hole in the area in which the data link meets with the normal area of the display area may be prevented from being perceived, thereby improving a quality of the display device.

Further, according to an embodiment of the present disclosure, as the quality of the display device is improved, reliability thereof may be secured, thereby improving a lifespan of the display panel and implementing a long-life display device.

The display device according to the present disclosure may be described as follows.

According to a first aspect of the present disclosure, there is provided a display device comprising: a display panel including a display area in which at least one pixel is disposed, and a non-display area disposed around the display area; a data driver disposed in the non-display area; at least one data wiring respectively connecting the at least one pixel to the data driver; and at least one first wiring disposed between at least two data wirings and in the non-display area, and extending into the display area, wherein the at least one first wiring is bent in the display area so as to intersect the data wirings, wherein the display area includes a first area where the at least one pixel is disposed, and a link area other than the first area, wherein the link area includes: a (1-1)-th area located on a lower portion of one of both opposing sides of the display area; and a (1-2)-th area located on a lower portion of the other of the both opposing sides of the display area, wherein the at least one first wiring is respectively connected to the at least one data wiring or at least one power wiring via a planar hole in each of the first area, the (1-1)-th area, and the (1-2)-th area.

According to some embodiments of the first aspect, the link area further includes a second area and a third area disposed between the (1-1)-th area and the (1-2)-th area.

According to some embodiments of the first aspect, the second area and the third area are disposed adjacent to each other.

According to some embodiments of the first aspect, each of the second area and the third area has a triangular shape in a plan view of the device.

According to some embodiments of the first aspect, the second area has a triangular shape, and the third area has an inverted triangle shape.

According to some embodiments of the first aspect, one of the at least one pixel includes an anode electrode, a light-emitting layer, and a cathode electrode.

According to some embodiments of the first aspect, the anode electrode adjacent to the planar hole extends into the planar hole so as to cover the planar hole and to be in contact with each of the at least one data wiring or each of the at least one power wiring.

According to some embodiments of the first aspect, an encapsulation layer is disposed on the light-emitting element in the display area, wherein the encapsulation layer includes: a first encapsulation layer disposed on the light-emitting element; a second encapsulation layer disposed on the first encapsulation layer; and a third encapsulation layer disposed on the second encapsulation layer.

According to some embodiments of the first aspect, a touch electrode is disposed on the encapsulation layer in the display area, wherein the touch electrode includes a first touch electrode and a second touch electrode.

According to some embodiments of the first aspect, a touch buffer layer is disposed on the encapsulation layer, wherein the first touch electrode is disposed on the touch buffer layer, wherein a touch insulating layer is disposed on the touch buffer layer and the first touch electrode, wherein the second touch electrode is disposed on the touch insulating layer.

According to a second aspect of the present disclosure, there is provided a display device comprising: a display panel including a light-emitting element, a display area, a non-display area and a bent area; a gate driver configured to supply a gate signal to the display panel; an upper substrate disposed on the display panel and in the display area; a bent protective layer disposed on an outer surface of a bent portion of the display panel and in the bent area; a data driver disposed under the bent portion of the display panel and in the non-display area and configured to supply a data voltage to the display panel; a controller configured to control the gate driver and the data driver; at least one data wiring respectively connecting the at least one pixel to the data driver; at least one power wiring for respectively supplying power to the at least one pixel; and at least one first wiring disposed between at least two data wirings and in a layer different from a layer of the at least one data wiring, wherein the at least one first wiring is bent in the display area so as to intersect the data wirings, wherein the display area includes a first area where the at least one pixel is disposed, and a link area other than the first area, wherein the link area includes: a (1-1)-th area located on a lower portion of one of both opposing sides of the display area; and a (1-2)-th area located on a lower portion of the other of the both opposing sides of the display area, wherein the at least one first wiring is respectively connected to the at least one data wiring or the at least one power wiring via a planar hole in each of the first area, the (1-1)-th area, and the (1-2)-th area.

According to some embodiments of the second aspect, an optical film is disposed on the display panel, wherein the upper substrate is disposed on the optical film through an adhesive, wherein a first backplate is disposed under the display panel, wherein a fixing member is disposed under the first backplate, wherein a second backplate is disposed under the fixing member through an adhesive member, wherein a bent portion of the display panel is disposed under the second backplate, wherein a bent protective layer is disposed under the bent portion of the display panel.

According to some embodiments of the second aspect, the at least one first wiring is respectively connected to the at least one data wiring or the at least one power wiring via a connection line filling the planar hole in each of the first area, the (1-1)-th area, and the (1-2)-th area.

Although the embodiments of the present disclosure have been described in more detail with reference to the accompanying drawings, the present disclosure is not necessarily limited to these embodiments, and may be modified in a various manner within the scope of the present disclosure. Accordingly, the embodiments as disclosed in the present disclosure are intended to describe rather than limit the technical idea of the present disclosure, and the scope of the technical idea of the present disclosure is not limited by these embodiments. Therefore, it should be understood that the embodiments described above are not restrictive but illustrative in all respects.

## Claims

1. A display device (10) comprising:
a display panel (10') including a display area (AA) in which at least one pixel (PX) is disposed, and a non-display area (NA) disposed around the display area (AA);
a data driver (D-IC) disposed in the non-display area (NA);
at least one data wiring (DL) respectively connecting the at least one pixel (PX) to the data driver (D-IC); and
at least one first wiring (SL1) disposed between at least two data wirings (DL) and in the non-display area (NA), and extending into the display area (AA), wherein the at least one first wiring (SL1) is bent in the display area (AA) so as to intersect the data wirings (DL),
wherein the display area (AA) includes a first area (①) where the at least one pixel (PX) is disposed, and a link area (LiA) other than the first area (①),
wherein the link area (LiA) includes:
a (1-1)-th area (①') located on a lower portion of one of both opposing sides of the display area (AA); and
a (1-2)-th area (①") located on a lower portion of the other of the both opposing sides of the display area (AA),
wherein the at least one first wiring (SL1) is respectively connected to the at least one data wiring (DL) or at least one power wiring (VSSL) via a planar hole (PLN_H) in each of the first area (①), the (1-1)-th area (①'), and the (1-2)-th area (①").

2. The display device (10) of claim 1, wherein the link area (LiA) further includes a second area (②) and a third area (③) disposed between the (1-1)-th area (①') and the (1-2)-th area (①").

3. The display device (10) of claim 2, wherein the second area (②) and the third area (③) are disposed adjacent to each other.

4. The display device (10) of claim 2 or 3, wherein each of the second area (②) and the third area (③) has a triangular shape in a plan view of the display device.

5. The display device (10) of claim 4, wherein the second area (②) has a triangular shape, and the third area (③) has an inverted triangle shape.

6. The display device (10) of any of claims 1 to 5, wherein one of the at least one pixel (PX) includes a light-emitting element (EL) comprising an anode electrode (600), a light-emitting layer (610), and a cathode electrode (620).

7. The display device (10) of claim 6, wherein the anode electrode (600) adjacent to the planar hole (PLN_H) extends into the planar hole (PLN_H) so as to cover the planar hole (PLN_H) and to be in contact with each of the at least one data wiring (DL) or each of the at least one power wiring (VSSL).

8. The display device (10) of claim 6 or 7, wherein an encapsulation layer (700) is disposed on the light-emitting element (EL) in the display area (AA),
wherein the encapsulation layer (700) includes:
a first encapsulation layer (710) disposed on the light-emitting element (EL);
a second encapsulation layer (720) disposed on the first encapsulation layer (710); and
a third encapsulation layer (730) disposed on the second encapsulation layer (720).

9. The display device (10) of claim 8, wherein a touch electrode (810, 830) is disposed on the encapsulation layer (700) in the display area (AA),
wherein the touch electrode (810, 830) includes a first touch electrode (810) and a second touch electrode (830).

10. The display device (10) of claim 9, wherein a touch buffer layer (800) is disposed on the encapsulation layer (700),
wherein the first touch electrode (810) is disposed on the touch buffer layer (800),
wherein a touch insulating layer (820) is disposed on the touch buffer layer (800) and the first touch electrode (810),
wherein the second touch electrode (830) is disposed on the touch insulating layer (820).

11. A display device (10) comprising:
a display panel (10') including a light-emitting element (EL), a display area (AA), a non-display area (NA) and a bent area (BA);
a gate driver (GIP) configured to supply a gate signal (SCAN) to the display panel (10');
an upper substrate (83) disposed on the display panel (10') and in the display area (AA);
a bent protective layer (34) disposed on an outer surface of a bent portion of the display panel (10') and in the bent area (BA);
a data driver (D-IC) disposed under the bent portion of the display panel (10') and in the non-display area (NA) and configured to supply a data voltage (Vdata) to the display panel (10');
a controller (T-Con) configured to control the gate driver (GIP) and the data driver (D-IC);
at least one data wiring (DL) respectively connecting at least one pixel (PX) in the display area (AA) to the data driver (D-IC);
at least one power wiring (VSSL) for respectively supplying power to the at least one pixel (PX); and
at least one first wiring (SL1) disposed between at least two data wirings (DL) and in a layer different from a layer of the at least one data wiring (DL), wherein the at least one first wiring (SL1) is bent in the display area (AA) so as to intersect the data wirings (DL),
wherein the display area (AA) includes a first area (①) where the at least one pixel (PX) is disposed, and a link area (LiA) other than the first area (①),
wherein the link area (LiA) includes:
a (1-1)-th area (①') located on a lower portion of one of both opposing sides of the display area (AA); and
a (1-2)-th area (①") located on a lower portion of the other of the both opposing sides of the display area (AA),
wherein the at least one first wiring (SL1) is respectively connected to the at least one data wiring (DL) or the at least one power wiring (VSSL) via a planar hole (PLN_H) in each of the first area (①), the (1-1)-th area (①'), and the (1-2)-th area (①").

12. The display device (10) of claim 11, wherein an optical film (81) is disposed on the display panel (10'),
wherein the upper substrate (83) is disposed on the optical film (81) through an adhesive (82),
wherein a first backplate (30) is disposed under the display panel (10'),
wherein a fixing member (31) is disposed under the first backplate (30),
wherein a second backplate (33) is disposed under the fixing member (31) through an adhesive member (32),
wherein a bent portion of the display panel (10') is disposed under the second backplate (33),
wherein a bent protective layer is disposed under the bent portion of the display panel (10').

13. The display device (10) of claim 11, wherein the at least one first wiring (SL1) is respectively connected to the at least one data wiring (DL) or the at least one power wiring (VSSL) via a connection line (CoL) filling the planar hole (PLN_H) in each of the first area (①), the (1-1)-th area (①'), and the (1-2)-th area (①").

14. A display device (10) comprising:
a display panel (10') including a display area (AA) in which at least one pixel (PX) is disposed, and a non-display area (NA) disposed around the display area (AA);
a data driver (D-IC) disposed in the non-display area (NA);
at least one data wiring (DL) respectively connecting the at least one pixel (PX) to the data driver (D-IC); and
a plurality of first wirings (SL1) disposed between at least two data wirings (DL) and in the non-display area (NA), and extending into the display area (AA), wherein the plurality of first wirings (SL1) are bent in the display area (AA) so as to intersect the data wirings (DL),
wherein the display area (AA) includes a first area (①) where the at least one pixel (PX) is disposed, and a link area (LiA) other than the first area (①),
wherein the link area (LiA) includes:
a (1-1)-th area (①') located on a lower portion of one of both opposing sides of the display area (AA); and
a (1-2)-th area (①") located on a lower portion of the other of the both opposing sides of the display area (AA),
wherein the plurality of first wirings (SL1) comprise a wiring connected to the at least one data wiring (DL) or at least one power wiring (VSSL) via a planar hole (PLN_H) in the first area (①), a wiring connected to a dummy wiring (Dm) extending in a column direction via a planar hole (PLN_H) in the (1-1)-th area (①'), and a wiring connected to the at least one data wiring (DL) via a planar hole (PLN_H) in the (1-2)-th area (①").
